# EUROPEAN PATENT APPLICATION

(11) **EP 2 985 783 A1**
(43) Date of publication of application: **17.02.2016**
(21) Application number: 14782453.6
(22) Date of filing: 09.04.2014
(51) Int. Cl.: H01L 21/304, C11D 7/32

(54) **CLEANING AGENT FOR METAL WIRING SUBSTRATE, AND METHOD FOR CLEANING SEMICONDUCTOR SUBSTRATE**

(30) Priority: 10.04.2013 JP 2013082539
(71) Applicant: Wako Pure Chemical Industries, Ltd., Osaka-shi Osaka 540-8605 (JP)
(72) Inventor: MIZUTA Hironori, Kawagoe-shi Saitama 350-1101 (JP); WATAHIKI Tsutomu, Kawagoe-shi Saitama 350-1101 (JP); MAESAWA Tsuneaki, Kawagoe-shi Saitama 350-1101 (JP)
(74) Representative: Hinkelmann, Klaus
(86) International application number: PCT/JP2014/060257
(87) International publication number: WO 2014/168166

(57) **Abstract**

It is a subject of the present invention to provide a cleaning agent for a substrate having a metal wiring, and a cleaning method for a semiconductor substrate comprising that the cleaning agent is used, by which following effects (1) to (5) are obtained, in a cleaning process after chemical mechanical polishing (CMP) in a manufacturing process of a semiconductor device. (1) Residues of fine particles (polishing agents) used in the CMP process, fine particles (metal particles) derived from a polished metal, an anticorrosive, and the like, can be removed sufficiently. (2) A coating film (protective film: oxidation resistant film) on a surface of the metal wiring, containing a complex between an anticorrosive, such as benzotriazole or quinaldic acid, and a surface metal of the metal wiring, formed in the CMP process, can be removed (stripped) sufficiently. (3) An oxide film containing a metal oxide can be formed after removal (stripping) of the coating film. (4) A semiconductor substrate can be obtained stably for a long period of time, without impairing flatness of the surface of the metal wiring (the surface of the oxide film containing the metal oxide), even leaving a substrate after the cleaning process after the CMP. (5) It is hard to deteriorate even after using the cleaning agent for a long period of time.

The present invention relates to a cleaning agent for a substrate having a metal wiring, comprising an aqueous solution containing (A) carboxylic acid having a nitrogen-containing heterocyclic ring and (B) alkylhydroxylamine, and having a pH of 10 or higher, as well as a cleaning method for a semiconductor substrate, comprising that the cleaning agent is used.

## Description

### TECHNICAL FIELD

The present invention relates to a cleaning agent for a substrate having a metal wiring, and a cleaning method for a semiconductor substrate comprising that the cleaning agent is used. In more details, the present invention relates to a cleaning agent for a substrate having a metal wiring, to be used in a process for cleaning a semiconductor substrate after a chemical mechanical polishing (CMP) process, in a manufacturing process of a semiconductor device typified by a silicon semiconductor, and a cleaning method for a semiconductor substrate comprising that the cleaning agent is used.

### BACKGROUND ART

In a semiconductor device typified by a silicon semiconductor or the like, a miniaturization and a high integration have been progressing, in compliance with market needs, such as higher performance, more compact sizing. Along with the miniaturization and the high integration, such a semiconductor substrate has been required that have a metal wiring having high conductivity or a multilayer wiring structure formed with the metal wirings in multilayer, or the like. In manufacturing such a semiconductor substrate, advanced planarizing technology has been essential, and a chemical mechanical polishing (hereafter it may be abbreviated as CMP) process for planarizing the semiconductor substrate by physical polishing has been introduced.

The CMP is a method for planarizing by polishing the metal wiring of the semiconductor substrate, a barrier metal, and the like, using slurry containing fine particles (polishing agents), such as silica, alumina. In the semiconductor substrate after the CMP process, for example, fine particles (polishing agents) used in the CMP process, fine particles (metal particles) derived from a polished metal, and the like, tend to remain. Such residues adversely affect electric characteristics of the semiconductor, such as short-circuiting between wirings, and resulting in decrease in reliability of the semiconductor device. Thus these residues are necessary to be removed by cleaning the semiconductor substrate after the CMP process.

On the other hand, the metal wiring to be used in the manufacturing process of such a semiconductor device has high conductivity, as well as high metallic activity, and is thus easily oxidized (corroded) by external environment. There has been a problem of increasing resistance of the metal wiring, or inducing short-circuiting between the wirings, due to such oxidation (corrosion). In addition, there is the case of increasing resistance of the metal wiring, or inducing short-circuiting between the wirings, caused by generation of the polishing residue, scratching or dishing of the metal wiring, in the CMP process. Accordingly, there has been carried out to suppress generation of the polishing residue, scratching or dishing of the metal wiring, while preventing oxidation (corrosion) of the metal wiring, by adding, an anticorrosive, for example, benzotriazoles (hereinafter, it may be abbreviated as BTAs), imidazoles, quinaldic acids (hereinafter, it may be abbreviated as QCAs), quinoline acids, and the like, in the CMP process, to form a coating film (protective film) containing the anticorrosive, such as BTA, on the surface of the metal wiring. Such an anticorrosive forms, for example, a complex with a mono-valent metal in the metal wiring such as a copper(I)-benzotriazole coating film (Cu(I)-BTA coating film), or a complex with a di-valent metal in the metal wiring such as a copper(II)-quinaldic acid coating film (Cu(II)-QCA coating film). It has been considered that such a complex suppresses generation of the polishing residue, scratch or dishing of the metal wiring, while preventing oxidation (corrosion) of the metal wiring, due to having a capability of protecting the metal wiring surface.

In the semiconductor substrate after the CMP process, as described-above, not only fine particles (polishing agents) used in the CMP process, fine particles (metal particles) derived from a polished metal, and the like easily remain but also the anticorrosive could remain. Accordingly, a cleaning process is necessary for removing residues, such as the fine particles (polishing agents) used in the CMP process, the fine particles (metal particles) derived from the polished metal, and the anticorrosive, such as BTA or QCA. As the cleaning agent after the CMP to be used in such a cleaning process, there have been known a composition for cleaning a semiconductor fabricated substance containing, for example, an ammonium hydroxide compound, a chelating agent and a corrosion prevention compound (for example, PATENT LITERATURE 1), a cleaning agent for a semiconductor having a copper wiring containing a specific cyclic amine, a polyphenol-type reducing agent having 2 to 5 hydroxide groups, and the like (for example, PATENT LITERATURE 2), a cleaning solution containing at least one kind of an organic alkali (for example, PATENT LITERATURE 3), a cleaning agent for a substrate comprising an organic acid having at least one carboxyl group and/or a chelating agent and a specific organic solvent (for example, PATENT LITERATURE 4), a cleaning agent for a substrate having a copper wiring containing a specific amino acid and an alkylhydroxylamine (for example, PATENT LITERATURE 5), a cleaning agent for a semiconductor having a copper wiring containing a specific amine, a specific polyphenol compound, and the like (for example, PATENT LITERATURE 6), and the like. In addition, although not supposing the cleaning agent after the CMP, there have also been known a rinsing composition comprising a water-soluble corrosion inhibitor, such as one kind of amino acid, and the like, (for example, PATENT LITERATURE 7), a residue cleaning agent for a copper wiring containing a specific amino acid (for example, PATENT LITERATURE 8), and a cleaning agent containing an alkali component and a hydrophilic organic solvent, and the like (for example, PATENT LITERATURE 9), as a cleaning agent for removing impurities (residues) on a semiconductor substrate.

On the other hand, in a recent manufacturing process of a semiconductor device, there may be the case where waiting time of a substrate at the end of the cleaning process after the CMP is long, because the substrate finished the cleaning process after the CMP requires time till going forward to the next process such as a lamination process of the metal wiring, due to complicated manufacturing process caused by miniaturization of metal wiring. In addition, in the case where the manufacturing process is stopped for a long period of time caused by troubles of manufacturing equipment, there has been increasing the situation where the substrate waits in the midst of the processes. Still more, there is also the case of removing a coating film derived from an anticorrosive at the metal wiring surface, in the cleaning process after the CMP, and protecting a zero-valent metal wiring exposed at the metal wiring surface, by forming a surface coating film by a metal oxide such as copper(I) oxide, because the coating film of the metal wiring surface, containing a complex between the anticorrosive and a surface metal of the metal wiring, formed in the CMP process, needs to be removed finally.

### CITATION LIST

### PATENT LITERATURE

PATENT LITERATURE 1: JP-A-2007-525836
PATENT LITERATURE 2: JP-A-2010-235725
PATENT LITERATURE 3: JP-A-2002-359223
PATENT LITERATURE 4: WO 2005/040324
PATENT LITERATURE 5: WO 2012/073909
PATENT LITERATURE 6: JP-A-2012-186470
PATENT LITERATURE 7: JP-A-2001-517863
PATENT LITERATURE 8: JP-A-2005-217114
PATENT LITERATURE 9: JP-A-2006-63201

### SUMMARY OF INVENTION

### TECHNICAL PROBLEM

However, in cleaning compositions or cleaning agents of, for example, PATENT LITERATURE 1 to 6, there have been not only a problem of insufficient removal performance of residues, such as the fine particles (polishing agents) used in the CMP process, the fine particles (metal particles) derived from the polished metal, and the anticorrosive, such as BTA or QCA, added for metal corrosion inhibition, or insufficient removal performance of the coating film (protective film: oxidation resistant film) of the metal wiring surface, containing the complex between the anticorrosive, such as BTA or QCA to be used in the CMP process, and the surface metal of the metal wiring, but also a problem of oxidation of the surface of the metal wiring, resulting in not flat surface, when the substrate cleaned with these compositions or cleaning agents is left as it is.

In addition, even when compositions or cleaning agents of, for example, PATENT LITERATURE 7 to 9 are used as a cleaning solution after the CMP process as described above, there is a problem of insufficient removal of the fine particles (metal particles) derived from the polished metal, or a problem of oxidation of the surface of the metal wiring, resulting in not flat surface, when the substrate cleaned with these compositions or cleaning agents is left as it is.

Further, in the cleaning process after the CMP in the manufacturing process of the semiconductor device, there are many cases where the same cleaning agent is used for a long period of time, aiming at cost reduction of the manufacturing process. Accordingly, a cleaning agent having early deterioration performance has a concern of not capable of providing a cleaned substrate stably, caused by change of cleaning performance with time.

In view of the above circumstances, it is an object of the present invention to provide a cleaning agent for a substrate having a metal wiring, and a cleaning method for a semiconductor substrate comprising that the cleaning agent is used, by which following effects (1) to (5) are obtained. (1) Residues of fine particles (polishing agents) used in CMP process, fine particles (metal particles) derived from a polished metal, an anticorrosive, and the like, can be removed sufficiently. (2) A coating film (protective film: oxidation resistant film) on the surface of the metal wiring, containing a complex between an anticorrosive, such as benzotriazole or quinaldic acid, and a surface metal of the metal wiring, formed in the CMP process, can be removed (stripped) sufficiently. (3) An oxide film containing a metal oxide can be formed after removal (stripping) of the coating film. (4) A semiconductor substrate can be obtained stably for a long period of time, without impairing flatness of the surface of the metal wiring (the surface of the oxide film containing the metal oxide), even leaving a substrate after the cleaning process after the CMP. (5) It is hard to deteriorate even after using the cleaning agent for a long period of time.

### SOLUTION TO PROBLEM

The present invention is an invention of a cleaning agent for a substrate having a metal wiring, comprising an aqueous solution containing (A) carboxylic acid having a nitrogen-containing heterocyclic ring and (B) alkylhydroxylamine, and having a pH of 10 or higher.

In addition, the present invention is an invention of a cleaning method for a semiconductor substrate, comprising that a cleaning agent for a substrate having a metal wiring, comprising an aqueous solution containing (A) carboxylic acid having a nitrogen-containing heterocyclic ring and (B) alkylhydroxylamine, and having a pH of 10 or higher is used.

### ADVANTAGEOUS EFFECTS OF INVENTION

The cleaning agent for the substrate having the metal wiring of the present invention is, in a manufacturing process of a semiconductor device, a cleaning agent to be used in a cleaning process for a semiconductor substrate after CMP process and a cleaning agent to be used preferably for a semiconductor substrate having, in particular, a copper wiring or a copper alloy wiring, and a cleaning agent exerting following effects (1) to (5). (1) Residues of fine particles (polishing agents) used in the CMP process, fine particles (metal particles) derived from a polished metal, an anticorrosive, and the like, can be removed sufficiently. (2) A coating film (protective film: oxidation resistant film) on the surface of the metal wiring, containing a complex between an anticorrosive, such as benzotriazole or quinaldic acid, and a surface metal of the metal wiring, formed in the CMP process, can be removed (stripped) sufficiently. (3) An oxide film containing a metal oxide can be formed after removal (stripping) of the coating film. (4) A semiconductor substrate can be obtained stably for a long period of time, without impairing flatness of the surface of the metal wiring (the surface of the oxide film containing the metal oxide), even leaving a substrate after the cleaning process after the CMP. (5) It is hard to deteriorate even after using the cleaning agent for a long period of time.

In addition, the cleaning method for the semiconductor substrate of the present invention is an effective method for cleaning the semiconductor substrate having the metal wiring, for example, a copper wiring, or the like, and by using the cleaning agent for the substrate having the metal wiring of the present invention, the semiconductor substrate can clean effectively and stably.

The present inventors have intensively studied a way to attain the above-described objects and found that only the cleaning agent, containing in combination of the carboxylic acid having the nitrogen-containing heterocyclic ring, among various carboxylic acids, and the alkylhydroxylamine, where a pH is adjusted to 10 or higher, can provide all of the above-described effects (1) to (5), and have thus completed the present invention.

### DESCRIPTION OF EMBODIMENTS

- A cleaning agent for a substrate having a metal wiring of the present invention - A cleaning agent for a substrate having a metal wiring of the present invention is a cleaning agent comprising an aqueous solution containing (A) carboxylic acid having a nitrogen-containing heterocyclic ring and (B) alkylhydroxylamine, and having a pH of 10 or higher.

The (A) carboxylic acid having a nitrogen-containing heterocyclic ring includes, for example, a carboxylic acid having a nitrogen-containing saturated heterocyclic ring, a carboxylic acid having a nitrogen-containing unsaturated heterocyclic ring, and the like.

The carboxylic acid having a nitrogen-containing saturated heterocyclic ring means a carboxylic acid which has at least one nitrogen atom, and may have a hetero atom, such as oxygen atom and sulfur atom, other than the nitrogen atom, and has a saturated (not having a double bond and a triple bond) cyclic structure, and a specific example of such a carboxylic acid having a nitrogen-containing saturated heterocyclic ring includes, for example, 4-carboxypiperidine, 2-carboxypiperazine, proline, and the like. Structural formulae of these carboxylic acids are shown below.

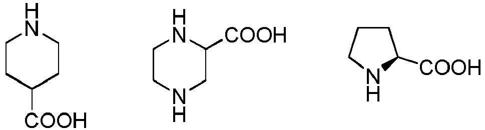

The carboxylic acid having a nitrogen-containing unsaturated heterocyclic ring means a carboxylic acid which has at least one nitrogen atom, and may have a hetero atom, such as oxygen atom and sulfur atom, other than the nitrogen atom, and has an unsaturated (having at least one double bond or triple bond) cyclic structure, and among such a carboxylic acid having a nitrogen-containing unsaturated heterocyclic ring, a carboxylic acid having a nitrogen-containing unsaturated heterocyclic ring and an amino group is included as a preferable carboxylic acid. Still more, among such a carboxylic acid having a nitrogen-containing unsaturated heterocyclic ring and an amino group, a carboxylic acid having a nitrogen-containing unsaturated heterocyclic ring and an amino group represented by following general formula (1) is more preferable, and among them, a carboxylic acid having a nitrogen-containing unsaturated heterocyclic ring and an amino group represented by following general formula (1') is still more preferable: 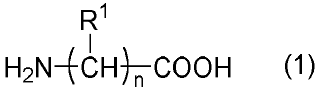 wherein n pieces of R¹ each independently represent a hydrogen atom or a group having a nitrogen-containing unsaturated heterocyclic ring, and n represents an integer from 1 to 3, provided that at least one of n pieces of R¹ is the group having a nitrogen-containing unsaturated heterocyclic ring; 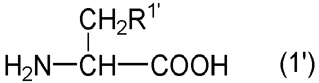 wherein R^{1'} represents a nitrogen-containing unsaturated heterocyclic ring group.

In the carboxylic acid having a nitrogen-containing unsaturated heterocyclic ring and an amino group, represented by the general formula (1), the group having a nitrogen-containing unsaturated heterocyclic ring represented by R¹ means an alkyl group having 1 to 3 carbon atoms which has at least one nitrogen atom, and may have a hetero atom, such as oxygen atom and sulfur atom, other than the nitrogen atom, and has an unsaturated (having at least one double bond or triple bond) cyclic structure, and a specific example of such a group having a nitrogen-containing unsaturated heterocyclic ring includes, for example, a pyrrolylmethyl group, a pyrrolylethyl group, a pyrrolylpropyl group, an imidazolylmethyl group, an imidazolylethyl group, an imidazolylpropyl group, a pyrazolylmethyl group, a pyrazolylethyl group, a pyrazolylpropyl group, an oxazolylmethyl group, an oxazolylethyl group, an oxazolylpropyl group, a thiazolylmethyl group, a thiazolylethyl group, a thiazolylpropyl group, a pyridinylmethyl group, a pyridinylethyl group, a pyridinylpropyl group, a pyrazinylmethyl group, a pyrazinylethyl group, a pyrazinylpropyl group, a pyrimidinylmethyl group, a pyrimidinylethyl group, a pyrimidinylpropyl group, an indolylmethyl group, an indolylethyl group, an indolylpropyl group, an isoindolylmethyl group, an isoindolylethyl group, an isoindolylpropyl group, a quinolinylmethyl group, a quinolinylethyl group, a quinolinylpropyl group, and the like, and among them, an imidazolylmethyl group, an imidazolylethyl group, an imidazolylpropyl group, an indolylmethyl group, an indolylethyl group, and an indolylpropyl group are preferable, and among them, an imidazolylmethyl group, and an indolylmethyl group are more preferable, and an imidazolylmethyl group is particularly preferable. It should be noted that "1 to 3 carbon atoms" in "the alkyl group having 1 to 3 carbon atoms" is the one which defines the carbon atoms of "the alkyl group", and means not to contain the carbon atoms of "cycle structure". In addition, the carbon atoms composing "nitrogen-containing unsaturated heterocyclic ring" (the above-described cyclic structure) is 3 to 9.

In the carboxylic acid having a nitrogen-containing unsaturated heterocyclic ring and an amino group, represented by the general formula (1), n is an integer from 1 to 3, and among them, an integer from 1 to 2 is preferable, and among them, 1 is more preferable.

In the carboxylic acid having a nitrogen-containing unsaturated heterocyclic ring and an amino group, represented by the general formula (1'), the nitrogen-containing unsaturated heterocyclic ring group represented by R^{1'} means the unsaturated (having at least one double bond or triple bond) heterocyclic ring group which has at least one nitrogen atom, and may have a hetero atom, such as oxygen atom and sulfur atom, other than the nitrogen atom, and a specific example of such a nitrogen-containing unsaturated heterocyclic ring group includes, a nitrogen-containing unsaturated heterocyclic ring having 3 to 9 carbon atoms, such as a pyrrolyl group, an imidazolyl group, a pyrazolyl group, an oxazolyl group, a thiazolyl group, a pyridinyl group, a pyrazinyl group, a pyrimidinyl group, an indolyl group, an isoindolyl group and a quinolinyl group, and among them, an imidazolyl group and an indolyl group are preferable, and among them, an imidazolyl group is particularly preferable.

A specific example of the carboxylic acid having a nitrogen-containing unsaturated heterocyclic ring includes, for example, 4-imidazolecarboxylic acid, 2-pyridinecarboxylic acid, 3-amino-1,2,4-triazole-5-carboxylic acid, 4,6-dimorpholine-4-yl-[1,3,5]triazine-2-carboxylic acid, histidine, tryptophan, and the like. Structural formulae of these carboxylic acids are shown below.

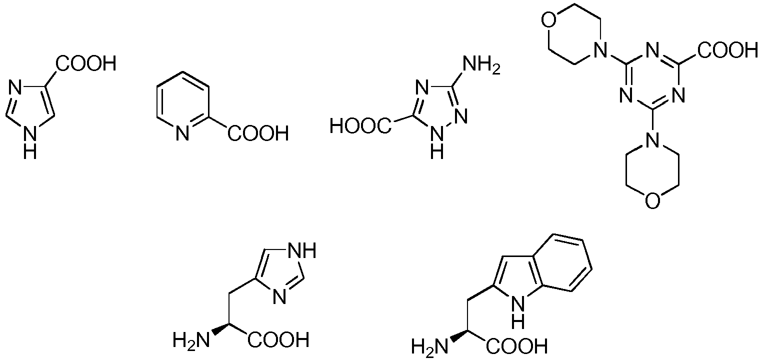

Among these (A) carboxylic acids having a nitrogen-containing heterocyclic ring, the carboxylic acid having a nitrogen-containing unsaturated heterocyclic ring is preferable, and among them, the carboxylic acid having a nitrogen-containing unsaturated heterocyclic ring and an amino group is more preferable. More specifically, 4-imidazolecarboxylic acid, 2-pyridinecarboxylic acid, 3-amino-1,2,4-triazole-5-carboxylic acid, 4,6-dimorpholine-4-yl-[1,3,5]triazine-2-carboxylic acid, histidine, tryptophan, and the like, which are the carboxylic acid having a nitrogen-containing unsaturated heterocyclic ring, are preferable, and among them, histidine, tryptophan, which are the carboxylic acid having a nitrogen-containing unsaturated heterocyclic ring and an amino group represented by general formulae (1) and (1'), are more preferable, and among them, histidine is particularly preferable. Histidine is a preferable carboxylic acid, from the viewpoint of being easily available, having high removing effect of residues of fine particles (polishing agents) used in the CMP process, fine particles (metal particles) derived from a polished metal, an anticorrosive, such as BTAor QCA, and still more having high removing (stripping) effect of a coating film (protective film: oxidation resistant film) on the surface of the metal wiring, containing a complex between an anticorrosive, such as BTA or QCA, and a surface metal of the metal wiring, formed in the CMP process.

These (A) carboxylic acids having a nitrogen-containing heterocyclic ring may be used alone or two or more kinds may be used in combination. In addition, a carboxylic acid derivative, such as a salt of the carboxylic acid and an ester of the carboxylic acid, may also be used, as long as it is converted to the (A) carboxylic acid having a nitrogen-containing heterocyclic ring in an aqueous solution. It should be noted that as these (A) carboxylic acids having a nitrogen-containing heterocyclic ring, commercial products may be used, or those synthesized as appropriate by a known method per se may be used.

The (B) alkylhydroxylamine includes, for example, the one represented by following general formula (2): 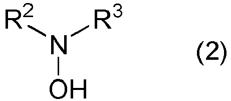 wherein R² represents an alkyl group having 1 to 6 carbon atoms, and R³ represents a hydrogen atom or an alkyl group having 1 to 6 carbon atoms.

In the alkylhydroxylamine represented by the general formula (2), the alkyl group having 1 to 6 carbon atoms represented by R² and R³ may be any of a straight chained, a branched, or a cyclic group, and specifically includes, for example, a methyl group, an ethyl group, a n-propyl group, an isopropyl group, a n-butyl group, an isobutyl group, a sec-butyl group, a tert-butyl group, a cyclobutyl group, a n-pentyl group, an isopentyl group, a sec-pentyl group, a tert-pentyl group, a neopentyl group, a 2-methylbutyl group, a 1,2-dimethylpropyl group, a 1-ethylpropyl group, a cyclopentyl group, a n-hexyl group, an isohexyl group, a sec-hexyl group, a tert-hexyl group, a neohexyl group, a 2-methylpentyl group, a 1,2-dimethylbutyl group, a 2,3-dimethylbutyl group, a 1-ethylbutyl group, a cyclohexyl group, and the like, and among them, a straight chained alkyl group having 2 to 3 carbon atoms, such as an ethyl group and a n-propyl group, is preferable, and among them, an ethyl group which is an alkyl group having 2 carbon atoms is more preferable.

A specific example of the alkylhydroxylamine represented by the general formula (2) includes, for example, N-methylhydroxylamine, N,N-dimethylhydroxylamine, N-ethylhydroxylamine, N,N-diethylhydroxylamine, N-n-propylhydroxylamine, N,N-di-n-propylhydroxylamine, N-isopropylhydroxylamine, N,N-diisopropylhydroxylamine, N-n-butylhydroxylamine, N,N-di-n-butylhydroxylamine, N-isobutylhydroxylamine, N,N-diisobutylhydroxylamine, N-sec-butylhydroxylamine, N,N-di-sec-butylhydroxylamine, N-tert-butylhydroxylamine, N,N-di-tert-butylhydroxylamine, N-cyclobutylhydroxylamine, N,N-dicyclobutylhydroxylamine, N-n-pentylhydroxylamine, N,N-di-n-pentylhydroxylamine, N-isopentylhydroxylamine, N,N-diisopentylhydroxylamine, N-sec-pentylhydroxylamine, N,N-di-sec-pentylhydroxylamine, N-tert-pentylhydroxylamine, N,N-di-tert-pentylhydroxylamine, N-neopentylhydroxylamine, N,N-dineopentylhydroxylamine, N-(2-methylbutyl)hydroxylamine, N,N-bis(2-methylbutyl)hydroxylamine, N-(1,2-dimethylpropyl)hydroxylamine, N,N-bis(1,2-dimethylpropyl)hydroxylamine, N-(1-ethylpropyl)hydroxylamine, N,N-bis(1-ethylpropyl)hydroxylamine, N-cyclopentylhydroxylamine, N,N-dicyclopentylhydroxylamine, N-n-hexylhydroxylamine, N,N-di-n-hexylhydroxylamine, N-isohexylhydroxylamine, N,N-diisohexylhydroxylamine, N-sec-hexylhydroxylamine, N,N-di-sec-hexylhydroxylamine, N-tert-hexylhydroxylamine, N,N-di-tert-hexylhydroxylamine, N-neohexylhydroxylamine, N,N-dineohexylhydroxylamine, N-(2-methylpentyl)hydroxylamine, N,N-bis(2-methylpentyl)hydroxylamine, N-(1,2-dimethylbutyl)hydroxylamine, N,N-bis(1,2-dimethylbutyl)hydroxylamine, N-(2,3-dimethylbutyl)hydroxylamine, N,N-bis(2,3-dimethylbutyl)hydroxylamine, N-(1-ethylbutyl)hydroxylamine, N,N-bis(1-ethylbutyl)hydroxylamine, N-cyclohexylhydroxylamine, N,N-dicyclohexylhydroxylamine, and the like.

Among the alkylhydroxylamine represented by the general formula (2), N-ethylhydroxylamine, N,N-diethylhydroxylamine and N-n-propylhydroxylamine are preferable, and among them, N,N-diethylhydroxylamine and N-n-propylhydroxylamine are more preferable, and N,N-diethylhydroxylamine is particularly preferable. These alkylhydroxylamines are preferable alkylhydroxylamines, from the viewpoint that oxidation of the surface of the metal wiring (the surface of the oxide film containing the metal oxide) is prevented, and a substrate having a flat surface of the wiring can be obtained, even when a substrate after cleaning is left as it is.

These (B) alkylhydroxylamines may be used alone, or two or more kinds may be used in combination. It should be noted that as these (B) alkylhydroxylamines, commercial products may be used, or those synthesized as appropriate by a known method per se may be used.

The cleaning agent for the substrate having the metal wiring of the present invention is an aqueous solution and is thus the cleaning agent containing water. Water is not especially limited as long as it is the one not affecting adversely on the substrate in the manufacturing process of the semiconductor device. A specific example of water includes, for example, purified water, such as distilled water, deionized water, and the like, and ultra pure water, and the like, and among them, ultra pure water is preferable. Ultra pure water is preferable water from the viewpoint of little containing impurities, and being difficult to affect adversely on the substrate in the manufacturing process after the cleaning process.

In the cleaning agent for the substrate having the metal wiring of the present invention, (C) alkali compound may be contained other than the above-mentioned (A) component and (B) component. The (C) alkali compound is used mainly to adjust a pH of an aqueous solution to alkaline.

A specific example of the (C) alkali compound includes, an alkanol amine, for example, such as monoethanolamine, diethanolamine, triethanolamine, monoisopropanolamine, tris(hydroxymethyl)aminomethane and 2-(morpholino)ethanol; a quaternary ammonium salt, for example, such as tetramethylammonium hydroxide, tetraethylammonium hydroxide, tetrapropylammonium hydroxide, tetrabutylammonium hydroxide and choline; an alkali metal hydroxide, for example, such as sodium hydroxide, potassium hydroxide; and the like; and among them, the quaternary ammonium salt, for example, such as tetramethylammonium hydroxide, tetraethylammonium hydroxide, tetrapropylammonium hydroxide, tetrabutylammonium hydroxide and choline, are preferable. Among such quaternary ammonium salts, tetramethylammonium hydroxide and choline are preferable, and among them, choline is more preferable.

These (C) alkali compounds may be used alone or two or more kinds may be used in combination. It should be noted that as these (C) alkali compounds, commercial products may be used.

There is the case where the one not to contain components other than the above-described (A) component, (B) component and (C) component is desirable as the cleaning agent for the substrate having the metal wiring of the present invention, from the viewpoint of being capable of cleaning a substrate without affecting adversely on a metal wiring, or the like. It should be noted that a phrase "not to contain other components (not to contain components other than (A), (B) and (C))" means that other components should not be contained in an amount equal to or more than amount which could influence adversely on cleaning of a substrate having a metal wiring, or the like. That is, it does not mean to exclude to contain other components in extremely trace amount (other components are contaminated in extremely trace amount), and means not contain substantially.

The cleaning agent for the substrate having the metal wiring of the present invention is an aqueous solution having a pH of 10 or higher, and among them, it is preferable to be an aqueous solution having a pH of 10 or higher and 13 or lower, and among them, it is more preferable to be an aqueous solution having a pH of 11.5 or higher and 12.5 or lower. By adjusting the cleaning agent for the substrate having the metal wiring of the present invention so as to have the pH in such a preferable range, such a substrate can be obtained, which does not impair planarizing of the surface of the metal wiring (the surface of the oxide film containing the metal oxide), even when a substrate after cleaning is left as it is. It should be noted that the pH adjustment is enough to be carried out by adjusting mainly the (C) alkali compound content.

In the cleaning agent for the substrate having the metal wiring of the present invention, it is desirable that concentrations of the (A) carboxylic acid having a nitrogen-containing heterocyclic ring, the (B) alkylhydroxylamine and the (C) alkali compound are adjusted to weight % concentration shown below.

The weight % concentration of the (A) carboxylic acid having a nitrogen-containing heterocyclic ring is usually 0.01 to 10% by weight, and preferably 0.01 to 3% by weight, as weight % of the (A) relative to total weight of the cleaning agent. The case where weight % of the (A) is below 0.01% by weight, there is a risk that residues of fine particles (polishing agents) used in the CMP process, fine particles (metal particles) derived from a polished metal, an anticorrosive, and the like could not be removed sufficiently, while the case where weight % is over 10% by weight, there is a risk that a metal wiring could be dissolved.

The weight % concentration of the (B) alkylhydroxylamine is usually 0.05 to 25% by weight, preferably 0.2 to 15% by weight, and more preferably 0.2 to 0.5% by weight, as weight % of the (B) relative to total weight of the cleaning agent. The case where weight % of the (B) is below 0.05% by weight, there is a risk that oxidation or corrosion of a metal wiring caused by dissolved oxygen in an aqueous solution could not be prevented sufficiently, while the case where weight % is over 25% by weight, there is a risk that phase separation could be caused without dissolving in water.

The weight % concentration of the (C) alkali compound is usually 0.01 to 5% by weight, and preferably 0.5 to 4% by weight, as weight % of the (C) relative to total weight of the cleaning agent.

As for the cleaning agent for the substrate having the metal wiring of the present invention, preparation method itself is not especially limited, as long as it is a method which is capable of preparing an aqueous solution containing the (A) carboxylic acid having a nitrogen-containing heterocyclic ring and the (B) alkylhydroxylamine, and the (C) alkali compound, as needed. A specific example of the preparation method includes a method for adding the (A) carboxylic acid having a nitrogen-containing heterocyclic ring and the (B) alkylhydroxylamine into an aqueous solution wherein the (C) alkali compound, such as choline was added to ultra pure water from which dissolved oxygen was removed by bubbling using inert gas, such as dry nitrogen gas or removed by other methods, and then stirring the aqueous solution to obtain the uniform aqueous solution, or the like.

### - A substrate as a cleaning object in the cleaning agent for the substrate having the metal wiring of the present invention -

In the cleaning agent for the substrate having the metal wiring of the present invention, the substrate to be a cleaning object is a substrate having at least a metal wiring. A specific example of the substrate in the substrate having the metal wiring includes, for example, a silicon (Si) substrate, a silicon carbide (SiC) substrate, a gallium arsenide (GaAs) substrate, a gallium phosphide (GaP) substrate, an indium phosphide (InP) substrate, or the like, and among them, a silicon (Si) substrate is preferable.

A specific example of the metal wiring in the substrate having the metal wiring includes, for example, a copper wiring, a tungsten wiring, an aluminum wiring, an alloy wiring made of these metals and other metals, or the like, and among them, a copper wiring and a copper alloy wiring are preferable. It should be noted that metals other than copper in the copper alloy wiring include metals, such as tungsten, aluminum, titanium, tantalum or chromium. When the cleaning agent for the substrate having the metal wiring of the present invention is used for the semiconductor substrate having the copper wiring or the copper alloy wiring, such effects can be exerted significantly, as compared with the case of other metals, that a coating film (protective film: oxidation resistant film) on the surface of the copper wiring, containing a complex between an anticorrosive, such as BTA or QCA, and a surface metal of the copper wiring or the copper alloy wiring, formed in the CMP process, can be removed (stripped) sufficiently; as well as an oxide film containing a copper oxide (such as copper(I) oxide) can be formed on the surface of the copper wiring or the copper alloy wiring, after removal (stripping); and still more a semiconductor substrate can be obtained, which does not impair planarizing of the surface of the copper wiring (the surface of the oxide film containing the copper oxide (such as the copper(I) oxide)).

The substrate having the metal wiring may have a barrier metal to prevent metallic diffusion to an insulating film. A specific example of the barrier metal includes, for example, titanium (Ti), titanium nitride (TiN), tantalum (Ta), tantalum nitride (TaN), manganese (Mn), cobalt (Co), ruthenium (Ru), or the like.

The substrate having the metal wiring may have an insulating film. A specific example of the insulating film includes, for example, a p-TEOS thermal oxide film, silicon nitride (SiN), nitride silicon carbide (SiCN), low-dielectric constant film Low-k (SiOC, SiC), or the like.

### - Use applications of the cleaning agent for the substrate having the metal wiring of the present invention -

As use applications of the cleaning agent for the substrate having the metal wiring of the present invention, it is preferable to use the cleaning agent in the cleaning process after the CMP process (treatment), namely it is preferable to use the cleaning agent for the substrate having the metal wiring of the present invention, as the cleaning agent after the CMP, and in particular, it is more preferable to use the cleaning agent as the cleaning agent after the CMP, in the case where the metal wiring is the copper wiring or the copper alloy wiring. By using the cleaning agent for the substrate having the metal wiring of the present invention as the cleaning agent after the CMP, not only residues, such as fine particles (polishing agents) used in the CMP process, fine particles (metal particles) derived from a polished metal, and an anticorrosive, such as BTA or QCA, can be removed sufficiently, but also a coating film (protective film: oxidation resistant film) on the surface of the metal wiring, containing a complex between an anticorrosive, such as BTA or QCA, and a surface metal of the metal wiring, formed in the CMP process, can be removed (stripped) sufficiently, as well as an oxide film containing a metal oxide can be formed on the surface of the metal wiring, after removal (stripping) of the coating film, and still more a semiconductor substrate can be obtained, which does not impair planarizing of the surface of the metal wiring (the surface of the oxide film containing the metal oxide).

It is particularly preferable to use the cleaning agent for the substrate having the metal wiring of the present invention as the cleaning agent after the CMP for the substrate having the copper wiring or the copper alloy wiring, and among them, it is desirable to use the cleaning agent as the cleaning agent after the CMP for a substrate polished with a polishing agent added with an anticorrosive, such as BTA or QCA, in the CMP process. The cleaning agent for the substrate having the metal wiring of the present invention is the cleaning agent which is capable of removing (stripping) sufficiently a coating film (protective film: oxidation resistant film) on the surface of the metal wiring, containing a complex between an anticorrosive, such as BTA or QCA, and a surface metal of the metal wiring, formed in the CMP process, and thus by application thereof to a substrate formed with such a coating film, effects of the present invention can be exerted significantly.

### - A cleaning method for a semiconductor substrate of the present invention -

A cleaning method for a semiconductor substrate of the present invention is a method for using a cleaning agent for a substrate having a metal wiring, comprising an aqueous solution containing (A) carboxylic acid having a nitrogen-containing heterocyclic ring and (B) alkylhydroxylamine, and having a pH of 10 or higher. That is, the cleaning method for the semiconductor substrate of the present invention is characterized by using the cleaning agent for the substrate having the metal wiring of the present invention, and the cleaning method itself is not especially limited.

Specific examples of the cleaning method for the semiconductor substrate of the present invention will be shown below. By preparing the cleaning agent for the substrate having the metal wiring of the present invention, which was prepared by the above-described preparation method so as to provide a predetermined concentration range, and by immersing the substrate having the metal wiring into the cleaning agent, cleaning can be carried out. It should be noted that a method of the cleaning is not limited to an immersion method, and other than the immersion method, a method carried out in this field, such as, a spinning (dropping) method or a spraying method, may be adopted as appropriate. In addition, any of the processing of a batch wafer processing, where multiple substrates are processed at one time, and a single wafer processing, where substrates are processed one by one, may be adopted.

A cleaning temperature in cleaning in the cleaning method for the semiconductor substrate of the present invention is not especially limited, as long as it is such a cleaning temperature as usually carried out in this field. A specific example of the cleaning temperature is, for example, 15 to 30°C.

A cleaning time in cleaning in the cleaning method for the semiconductor substrate of the present invention is not especially limited, as long as it is such a cleaning time as usually carried out in this field. A specific example of the cleaning time is, for example, 15 to 120 seconds, in consideration of cleaning efficiency.

### EXAMPLES

Explanation on the present invention will be given specifically below based on Examples and Comparative Examples, however, the present invention should not be limited to these Examples. It should be noted that "%" in the following Examples and Comparative Examples is weight base (w/w %) unless specified in particular.

### - Preparation method of substrate A for the evaluation -

A wafer was purchased, wherein a surface of SEMATECH 845 (copper wiring, barrier metal: TaN, oxide film: TEOS; manufactured by SEMATECH Co., Ltd.), having a diameter of 8 inch, was polished with polishing slurry containing benzotriazole (BTA), and planarized, and then cleaned with pure water. The wafer was immersed in a 1% benzotriazole (BTA) aqueous solution for 1 hour, and a copper(I)-benzotriazole coating film was formed on the surface of the copper wiring, followed by rinsing with pure water using a single wafer processing cleaning machine (multi-spinner; manufactured by Kaijo Corp.), and spin-drying. Next, the wafer was cut to small pieces having a size of about 2 cm × 2 cm, to be adopted as a substrate A for the evaluation.

### - Preparation method of substrate B for the evaluation -

A substrate was purchased, wherein a surface of a copper plated substrate (silicon substrate having 1.5 µm of copper plated film / copper seed layer / titanium barrier layer / 300 nm of silicon oxide film), having a diameter of 8 inch, was polished with polishing slurry containing benzotriazole (BTA), and planarized, and then cleaned with pure water. The substrate was immersed in a 1% benzotriazole (BTA) aqueous solution for 1 hour, and a copper(I)-benzotriazole coating film was formed on the surface of the copper plate, followed by rinsing with pure water using a single wafer processing cleaning machine (multi-spinner; manufactured by Kaijo Corp.), and spin-drying. Next, the substrate was cut to small pieces having a size of about 2 cm × 2 cm, to be adopted as a substrate B for the evaluation.

### - Preparation method of substrate C for the evaluation -

A substrate was purchased, wherein a surface of a copper plated substrate (silicon substrate having 1.5 µm of copper plated film / copper seed layer / titanium barrier layer / 300 nm of silicon oxide film), having a diameter of 4 inch, was polished with polishing slurry containing benzotriazole (BTA), and planarized, and then cleaned with pure water. The substrate was cleaned using methanol (MeOH) and isopropanol (IPA) in this order, followed by drying with nitrogen gas. Next, the substrate was immersed in a 1 % quinaldic acid (QCA) aqueous solution containing 0.07% hydrogen peroxide water, for 30 seconds, and a copper(II)-quinaldic acid coating film was formed on the surface of the copper plate, followed by rinsing with pure water using a single wafer processing cleaning machine (multi-spinner; manufactured by Kaijo Corp.), and spin-drying. Next, the substrate was cut to small pieces having a size of about 2 cm × 2 cm, to be adopted as a substrate C for the evaluation.

Examples 1 to 8 and Comparative Examples 1 to 13: Evaluations of (a) to (e) using various kinds of aqueous solutions (cleaning agents)

### (a) Corrosion evaluation of substrate A

Each 100 mL of an aqueous solution (cleaning agent) was prepared, which contains each of various kinds of chelating agents shown in Table 1, and each of various kinds of reducing agents shown in Table 1, in each % by weight shown in Table 1, and was adjusted to provide a predetermined pH value using choline. Next, the substrate A was put into each of these aqueous solutions (cleaning agents), and immersed for 1 hour under stirring. After that, the substrate A was taken out of the aqueous solution (cleaning agent), rinsed for 1 minute using flowing pure water, dried with nitrogen gas, followed by storing for 1 day in a thermostat chamber maintained at a humidity of 75% and a temperature of 40°C. As for the substrate A after storage for 1 day, the corrosion degree of the surface of the copper wiring was observed using a field emission-type scanning electron microscope (FE-SEM) (S-4800; manufactured by Hitachi High-Technology Corp.). Results thereof are shown in Table 1. It should be noted that in the Table, "○" means no confirmation of corrosion of the copper wiring, "×" means confirmation of large corrosion of the copper wiring, and "-" means unadministered.

### (b) Evaluation of roughness (unevenness) change of the substrate A when 1 day and 3 days elapsed after cleaning

Each 100 mL of an aqueous solution (cleaning agent) was prepared, which contains each of various kinds of chelating agents shown in Table 1, and each of various kinds of reducing agents shown in Table 1, in each % by weight shown in Table 1, and was adjusted to provide a predetermined pH value using choline. Next, the substrate A was put into each of these aqueous solutions (cleaning agents), and immersed for 1 hour under stirring. After that, the substrate A was taken out of the aqueous solution (cleaning agent), rinsed for 1 minute using flowing pure water, dried with nitrogen gas, followed by storing for 1 day and 3 days in a thermostat chamber maintained at a humidity of 75 % and a temperature of 40°C. As for the substrate A after storage for 1 day, and the substrate A after storage for 3 days, change of roughness (unevenness) of the surface of the copper wiring was measured using a scanning probe microscope (SPM) (Nano-Navi-S-image; manufactured by SII Nanotechnology Co., Ltd.) in a dynamic-force-mode (DFM mode). Results thereof are shown in Table 1. It should be noted that larger numerical value of the roughness (unevenness) was judged to be the poorer state having a rough surface of the copper wiring, and the case, where numerical value of the roughness (unevenness) was varied between after elapse of 1 day and after elapse of 3 days, was judged that negative change was caused in the surface of the copper wiring by roughening with elapse of time.

### (c) Evaluation of removal efficiency of the copper(I)-benzotriazole coating film or the copper(II)-quinaldic acid coating film, and evaluation of film thickness of a copper(I) oxide coating film in the substrates B and C

Each 100 mL of an aqueous solution (cleaning agent) was prepared, which contains each of various kinds of chelating agents shown in Table 1, and each of various kinds of reducing agents shown in Table 1, in each % by weight shown in Table 1, and was adjusted to provide a predetermined pH value using choline. Next, the substrates B and C were put into each of these aqueous solutions (cleaning agents), and immersed for 1 hour under stirring. After that, the substrates B and C were taken out of the aqueous solution (cleaning agent), rinsed for 1 minute using flowing pure water, dried with nitrogen gas, followed by storing for 1 day in a thermostat chamber maintained at a humidity of 75% and a temperature of 40°C. As for each of the substrates B and C after storage for 1 day, it was confirmed whether the copper(I)-benzotriazole coating film and the copper(II)-quinaldic acid coating film were removed or not, by measuring N 1s using an X-ray photoelectron spectrometer (XPS) (AXIS-His, manufactured by Kratos Co., Ltd.). That is, by measuring N 1s of the substrates B and C after storage for 1 day, and when it was the same intensity as that of N 1 s spectrum of a copper plated substrate not having the copper(I)-benzotriazole coating film and the copper(II)-quinaldic acid coating film (a purchased product), it was judged that the copper(I)-benzotriazole coating film or the copper(II)-quinaldic acid coating film has been removed. At the same time, as for each of the substrates B and C, existence ratio of copper(I) oxide to metal copper was calculated from intensities of analysis lines of copper(I) oxide formed on the surface of the copper plate, and metal copper, by measuring the LMM analysis line of copper, using an X-ray photoelectron spectrometer (XPS) (AXIS-His, manufactured by Kratos Co., Ltd.). Still more, existence ratio of copper(I) oxide formed at the inside of the copper plating to metal copper after etching was calculated, using the similar method, by etching the surfaces of the substrates B and C after storage for 1 day for 35 seconds (etching amount of 3.5 nm in silicon dioxide equivalent), respectively, using an argon sputtering device built in the X-ray photoelectron spectrometer (XPS). Results thereof are shown in Table 1. It should be noted that when numerical value of the existence ratio of copper(I) oxide to metal copper on the surface of the substrate before etching, and numerical value of the existence ratio of copper(I) oxide to metal copper in the substrate after etching are both the larger, it was judged that the copper(I) oxide coating film having the thicker film thickness has been formed.

### (d) Evaluation of removal efficiency of silicon dioxide, and silicon dioxide and copper(II) ion

The solution, where 0.2 g of a silicon dioxide particle (particle size: 70 nm; produced by Wako Pure Chemical Industries, Ltd.) was dispersed into 10 mL of ultra pure water using ultrasonic waves for 10 minutes, was prepared as a dispersion solution of silicon dioxide. Next, each 10 mL of an aqueous solution (cleaning agent), which contains each of various kinds of chelating agents shown in Table 1, and each of various kinds of reducing agents shown in Table 1, in each % by weight shown in Table 1, was poured in a centrifuge tube, and the solution, where 100 µL of the above-described dispersion solution of silicon dioxide was further added, was prepared as a measurement solution 1. In addition, each 10 mL of an aqueous solution (cleaning agent), which contains each of various kinds of chelating agents shown in Table 1, and each of various kinds of reducing agents shown in Table 1, in each % by weight shown in Table 1, was poured in a centrifuge tube, and the solution, where 100 µL of the above-described dispersion solution of silicon dioxide and 100 µL of an aqueous solution of copper sulfate (CuSO₄) was further added, was prepared as a measurement solution 2. Removal efficiency of polishing fine particles (polishing agents) themselves, as well as, in the case where the polishing fine particles (polishing agents) and the copper(II) ion (fine particles derived from a metal (metal particles)) are coexistent, removal efficiency of these fine particles were evaluated, by measuring zeta potentials of silicon dioxide, and the silicon dioxide and copper(II) ion. Results thereof are shown in Table 1. It should be noted that larger minus numerical value of the zeta potential was judged to show the more superior removal efficiency of the polishing fine particles (polishing agents) or the copper(II) ion (fine particles derived from the metal (metal particles)) derived from copper sulfate.

### (e) Evaluation of stability of the cleaning agent

Each 50 mL of an aqueous solution (cleaning agent) was prepared, which contains each of various kinds of chelating agents shown in Table 1, and each of various kinds of reducing agents shown in Table 1, in each % by weight shown in Table 1, and was adjusted to provide a predetermined pH value using choline. Next, each of these aqueous solutions (cleaning agents) was poured in a 100 mL container made of polyethylene, sealed tightly and enclosed. After that, the container made of polyethylene, in which the aqueous solution (cleaning agent) was enclosed, was stored for one week in a thermostat chamber maintained at a temperature of 40°C (a storage solution A). After elapse of one week, an aqueous solution (cleaning agent) was newly prepared similarly as above (a solution B), and colors of the aqueous solutions were compared between the storage solution A and the solution B. Results thereof are shown in Table 1. It should be noted that colors of the solution B just after preparation were all colorless and clear, and the case where coloring was observed in the storage solution A was judged to have poor stability of the cleaning agent. It should be noted that in the Table, "○" means no observation of coloring of the cleaning agent, and "×" means observation of coloring of the cleaning agent.

**[Table 1]**

| | Chelating agent | wt % | Reducing agent | wt% | pH | Evaluation method (a) | Evaluation method (b) | | Evaluation method (c) | | | | Evaluation method (d) | | Evaluation method (e) |
|---|---|---|---|---|---|---|---|---|---|---|---|---|---|---|---|
| | | | | | | Corrosion | Roughness | | BTA coating film | QCA coating film | Film thickness of Cu₂O coating film | | Zeta potential | | Stability of cleaning agent |
| | | | | | | | After 1 day | After 3 days | | | Before etching | After etching | Only SiO₂ | SiO₂+ Cu²⁺ | |
| Example 1 | histidine | 0.1 | DEHA | 0.15 | 10.5 | ○ | 1.9 | 5.8 | removed | removed | 1.1 | 0.6 | -60 | -42 | ○ |
| Example 2 | histidine | 0.1 | DEHA | 0.15 | 11.5 | ○ | 1.7 | 6.0 | removed | removed | 1.1 | 0.7 | -55 | -44 | ○ |
| Example 3 | histidine | 0.1 | DEHA | 0.15 | 12.5 | ○ | 2.9 | 4.5 | removed | removed | 1.2 | 0.7 | -60 | -47 | ○ |
| Example 4 | histidine | 0.1 | DEHA | 0.24 | 11.5 | ○ | 1.7 | 2.0 | removed | removed | 1.1 | 1.0 | -60 | -45 | ○ |
| Example 5 | histidine | 0.1 | DEHA | 0.30 | 11.5 | ○ | 1.8 | 1.9 | removed | removed | 1.2 | 1.1 | -55 | -44 | ○ |
| Example 6 | histidine | 0.15 | DEHA | 0.24 | 12.5 | ○ | 1.8 | 2.0 | removed | removed | 1.1 | 1.1 | -60 | -45 | ○ |
| Example 7 | 4-imidazolecarboxylic acid | 0.5 | DEHA | 0.24 | 11.5 | ○ | 1.9 | 2.1 | removed | removed | 1.0 | 1.0 | -55 | -40 | ○ |
| Example 8 | 3-amino-1,2,4-triazole-5-carboxylic acid | 0.1 | DEHA | 0.24 | 11.5 | ○ | 1.8 | 2.0 | removed | removed | 1.0 | 1.0 | -55 | -38 | ○ |
| Comparative Example 1 | histidine | 0.1 | - | | 11.5 | - | 6.3 | 9.1 | - | - | 0.4 | 0.2 | -58 | -38 | ○ |
| Comparative Example 2 | histidine | 0.1 | ascorbic acid | 0.24 | 11.5 | - | 1.8 | 2.0 | removed | removed | 1.1 | 1.0 | -55 | -45 | × |
| Comparative Example 3 | histidine | 0.1 | HA | 0.15 | 11.5 | - | 2.2 | 6.5 | removed | removed | 0.6 | 0.3 | -58 | -40 | ○ |
| Comparative Example 4 | glutamic acid | 0.1 | DEHA | 1.00 | 11.5 | ○ | 1.8 | 3.7 | remained | removed | 1.0 | 1.0 | -60 | -45 | ○ |
| Comparative Example 5 | glutamic acid | 0.1 | DEHA | 0.15 | 11.5 | ○ | 1.7 | 4.0 | remained | removed | 1.1 | 0.6 | -59 | -44 | ○ |
| Comparative Example 6 | glutamic acid | 0.1 | DEHA | 0.15 | 12.5 | ○ | 1.8 | 3.3 | remained | removed | 1.1 | 0.7 | -58 | -43 | ○ |
| Comparative Example 7 | glutamic acid | 0.1 | DEHA | 0.24 | 11.5 | ○ | 1.7 | 3.6 | remained | removed | 1.1 | 0.6 | -53 | -45 | ○ |
| Comparative Example 8 | glutamic acid | 0.1 | DEHA | 0.30 | 11.5 | ○ | 1.8 | 3.7 | remained | removed | 1.1 | 0.7 | -55 | -45 | ○ |
| Comparative Example 9 | glutamic acid | 0.1 | DEHA | 0.24 | 12.5 | ○ | 1.8 | 4.8 | remained | removed | 1.1 | 0.5 | -57 | -45 | ○ |
| Comparative Example 10 | aspartic acid | 0.1 | DEHA | 0.24 | 11.5 | ○ | 1.8 | 3.6 | remained | removed | 1.1 | 0.6 | -57 | -44 | ○ |
| Comparative Example 11 | bicine | 0.1 | DEHA | 0.24 | 11.5 | ○ | 1.9 | 4.1 | remained | removed | 1.1 | 0.7 | -59 | -44 | ○ |
| Comparative Example 12 | tricine | 0.1 | DEHA | 0.24 | 11.5 | ○ | 1.8 | 4.3 | remained | removed | 1.2 | 0.7 | -56 | -43 | ○ |
| Comparative Example 13 | sarcosine | 0.1 | DEHA | 0.15 | 11.5 | ○ | 2.0 | 4.3 | remained | remained | 1.0 | 0.7 | -58 | -40 | ○ |
| DEHA: N,N-diethylhydroxylamine | | | | | | | | | | | | | | | |
| HA: hydroxylamine | | | | | | | | | | | | | | | |
| bicine: N,N-bis(2-hydroxyethyl)glycine | | | | | | | | | | | | | | | |
| tricine: N-[tris(hydroxymethyl)methyl]glycine | | | | | | | | | | | | | | | |
| sarcosine: N-methylglycine | | | | | | | | | | | | | | | |

As is clear from results of Examples 1 to 8, and Comparative Examples 1 to 13, it was clarified that, the cleaning agent of Comparative Example 1 is not capable of forming a coating film of copper(I) oxide in sufficient thickness, and a surface of a copper plate was oxidized with elapse of time, resulting in large change of roughness (unevenness) of the surface of the copper plate. In addition, it was clarified that, the cleaning agent of Comparative Example 2 has poor stability of the cleaning agent, resulting in deterioration of the cleaning agent itself during use for a long period of time, and thus it is not capable of providing a purified substrate stably. Still more, it was clarified that, the cleaning agent of Comparative Example 3 is capable of removing a copper(I)-benzotriazole coating film and a copper(II)-quinaldic acid coating film, but it is not capable of forming a coating film of copper(I) oxide in sufficient thickness onto a surface of a copper plate after these coating films were removed, and the surface of the copper plate was oxidized with elapse of time, resulting in large change of roughness (unevenness) of the surface of the copper plate. It was clarified that, the cleaning agents of Comparative Examples 4 to 13 are not capable of sufficiently removing a copper(I)-benzotriazole coating film formed on a surface of a copper plate. On the contrary, it was clarified that, the cleaning agents for the substrate having the metal wiring of the present invention of Examples 1 to 8, i.e. the cleaning agents, where the (A) carboxylic acid having a nitrogen-containing heterocyclic ring as a chelating agent, and the (B) alkylhydroxylamine as a reducing agent are combined, are not only capable of sufficiently removing polishing fine particles (polishing agents), and fine particles (metal particles) derived from a metal, but also are the cleaning agents not causing problems clarified in the cleaning agents of Comparative Examples 1 to 13. Still more, it was clarified that, among the cleaning agents for the substrate having the metal wiring of the present invention of Examples 1 to 8, in the case of using the cleaning agents of Examples 4 to 8, such a substrate can be obtained that a surface of a copper plate is little oxidized, and has more flat plated surface even after 3 days elapsed after cleaning.

As is clear from the above results, it was clarified that, the cleaning agent for the substrate having the metal wiring of the present invention are the cleaning agent superior in removing performance of residues of, for example, fine particles (polishing agents) used in the CMP process, fine particles (metal particles) derived from a polished metal, an anticorrosive, and the like. In addition, it was clarified that, the cleaning agent for the substrate having the metal wiring of the present invention is capable of removing (stripping) sufficiently a coating film (protective film: oxidation resistant film) on a surface of a metal wiring, containing a copper(I)-benzotriazole complex, a copper(II)-quinaldic acid complex, and the like, formed in the CMP process, and still more is capable of forming a metal oxide film containing a metal oxide in sufficient thickness on the surface of the metal wiring where these coating films are removed (stripped). In addition, it was clarified that, the cleaning agent for the substrate having the metal wiring of the present invention is capable of providing a semiconductor substrate having a flat surface, without oxidizing a surface of a metal wiring (surface of oxide film containing metal oxide), even when a substrate after cleaning is left as it is. Still more, it was clarified that, the cleaning agent for the substrate having the metal wiring of the present invention is capable of providing the above-described effects for a long period of time, because of being the cleaning agent having high stability and is hard to deteriorate. From these results, it was clarified that, the cleaning agent for the substrate having the metal wiring of the present invention is a preferable cleaning agent as the cleaning agent after the CMP process.

### INDUSTRIAL APPLICABILITY

The cleaning agent for the substrate having the metal wiring of the present invention is a cleaning agent to be used in a cleaning process for a semiconductor substrate after CMP process in a manufacturing process of a semiconductor device, and a preferable cleaning agent as the cleaning agent after the CMP, in particular, for a semiconductor substrate having a copper wiring or a copper alloy wiring.

The cleaning method for the semiconductor substrate of the present invention is a method which is capable of effectively cleaning a surface of a semiconductor substrate having a metal wiring, such as a copper wiring, and a suitable method for cleaning, in particular, a semiconductor substrate having a metal wiring, such as a copper wiring, formed with a coating film (protective film: oxidation resistant film) on a surface of a metal wiring, containing a complex between an anticorrosive, such as BTA or QCA, and a surface metal of the metal wiring on the surface of the semiconductor substrate.

## Claims

1. A cleaning agent for a substrate having a metal wiring, comprising an aqueous solution containing (A) carboxylic acid having a nitrogen-containing heterocyclic ring and (B) alkylhydroxylamine, and having a pH of 10 or higher.

2. The cleaning agent according to claim **1,** wherein the (A) carboxylic acid having a nitrogen-containing heterocyclic ring is a carboxylic acid having a nitrogen-containing unsaturated heterocyclic ring.

3. The cleaning agent according to claim **1,** wherein the (A) carboxylic acid having a nitrogen-containing heterocyclic ring is a carboxylic acid having a nitrogen-containing unsaturated heterocyclic ring and an amino group.

4. The cleaning agent according to claim **3,** wherein the carboxylic acid having a nitrogen-containing unsaturated heterocyclic ring and an amino group is the one represented by general formula (1): 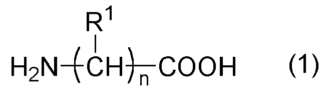 wherein n pieces of R¹ each independently represent a hydrogen atom or a group having a nitrogen-containing unsaturated heterocyclic ring, and n represents an integer from 1 to 3, provided that at least one of n pieces of R¹ is the group having a nitrogen-containing unsaturated heterocyclic ring.

5. The cleaning agent according to claim **3,** wherein the carboxylic acid having a nitrogen-containing unsaturated heterocyclic ring and an amino group is the one represented by general formula (1'): 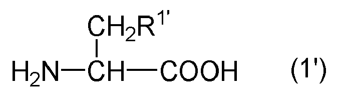 wherein R^{1'} represents a nitrogen-containing unsaturated heterocyclic ring group.

6. The cleaning agent according to claim **3,** wherein the carboxylic acid having a nitrogen-containing unsaturated heterocyclic ring and an amino group is histidine.

7. The cleaning agent according to claim **1,** wherein the (B) alkylhydroxylamine is the one represented by general formula (2): 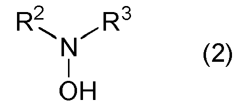 wherein R² represents an alkyl group having 1 to 6 carbon atoms, and R³ represents a hydrogen atom or an alkyl group having 1 to 6 carbon atoms.

8. The cleaning agent according to claim **1,** wherein the (B) alkylhydroxylamine is N,N-diethylhydroxylamine or N-n-propylhydroxylamine.

9. The cleaning agent according to claim **1,** wherein the (B) alkylhydroxylamine is N,N-diethylhydroxylamine.

10. The cleaning agent according to claim **1,** wherein the pH is 10 or higher and 13 or lower.

11. The cleaning agent according to claim **1,** further comprising (C) alkali compound.

12. The cleaning agent according to claim **11,** wherein the (C) alkali compound is a quaternary ammonium salt.

13. The cleaning agent according to claim **12,** wherein the quaternary ammonium salt is tetramethylammonium hydroxide or choline.

14. The cleaning agent according to claim **11,** comprising 0.01 to 10% by weight of the (A) carboxylic acid having a nitrogen-containing heterocyclic ring, 0.05 to 25% by weight of the (B) alkylhydroxylamine, and 0.01 to 5% by weight of the (C) alkali compound.

15. The cleaning agent according to claim **1,** wherein the metal wiring is a copper wiring or a copper alloy wiring.

16. A cleaning method for a semiconductor substrate, comprising that the cleaning agent according to claim **1** is used.

17. The cleaning method according to claim **16,** wherein the semiconductor substrate is a semiconductor substrate having a copper wiring or a copper alloy wiring.

18. The cleaning method according to claim **16,** wherein the semiconductor substrate is the one after a chemical mechanical polishing (CMP) process.

19. The cleaning method according to claim **17,** for removing a coating film on the surface of the copper wiring or the copper alloy wiring, derived from at least any of benzotriazole or a derivative thereof, quinaldic acid or a derivative thereof, and quinoline acid or a derivative thereof.

20. The cleaning method according to claim **17,** for removing at least any of copper(II) hydroxide and copper(II) oxide.
